Europäisches Patentamt

European Patent Office

Office européen des brevets

⑩

(11) Publication number: **0 097 225**
**B1**

(12)

# EUROPEAN PATENT SPECIFICATION

(45) Date of publication of patent specification: 16.07.86

(21) Application number: 83103165.3

(22) Date of filing: 30.03.83

(51) Int. Cl.⁴: **C 09 J 3/00**, C 09 J 3/14, C 09 J 5/00, C 08 J 3/28, C 08 K 7/20

(54) Radiation sensitive adhesive.

(30) Priority: 22.06.82 US 391058
06.01.83 US 456182

(43) Date of publication of application:
04.01.84 Bulletin 84/01

(45) Publication of the grant of the patent:
16.07.86 Bulletin 86/29

(84) Designated Contracting States:
DE FR GB IT

(56) References cited:
DE-A-2 536 319
GB-A-1 576 911

(73) Proprietor: International Business Machines Corporation
Old Orchard Road
Armonk, N.Y. 10504 (US)

(72) Inventor: Legg, Roderick Eugene
1153 East Third Avenue
Broomfield Colorado 80020 (US)
Inventor: Quist, Frederick Fenn, Jr.
231 Forest Lane
Boulder, Colorado 80302 (US)
Inventor: Schwander, Jeffrey Darrell
6905 Conifer Court
Longmont Colorado 80501 (US)
Inventor: Simson, Lowell Marr
1366 Caledonia Circle
Louisville Colorado 80026 (US)

(74) Representative: Ahlman, Bertel et al
IBM Svenska AB Box 962
S-18 109 Lidingö (SE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to radiation sensitive adhesives.

It is known that radiation sensitive adhesives allow a relatively long time during which the parts to be attached can be position-adjusted, and that after such adjustment has been accurately accomplished, the adhesive can be activated by radiation—in a manner which is certain not to disturb the critical relative positions of the parts. The *IBM Technical Disclosure Bulletin* of December 1977, at page 2609, describes the formulation of one such adhesive, which is activated by ultraviolet light.

A problem arises where the adhesive is between parts which render the bulk of the adhesive inaccessible to direct application of the sensitizing radiation.

Heretofore, it has been considered inappropriate to use radiation sensitive glues or adhesives in certain environments, and more specifically, radiation sensitive glues or adhesives have been recommended for use only in those situations where the glue or adhesive could be full-surface illuminated as the glue or adhesive was activated. Without such total illumination of the glue or adhesive, the resulting bond between the parts was likely to suffer deterioration with time, in that surfaces not illuminated would either not cure at all or cure at a different rate to the remainder. If the glue or adhesive did totally cure, dimensional changes were likely to result.

As a result, the utility of this class of adhesive was limited.

An object of the present invention is to extend the utility of radiation sensitive adhesives to situations where the parts to be glued or secured leave some, but not all, of the adhesive exposed for activating radiation after the parts have been brought to their final desired relative positions.

Another object of the present invention is to extend the utility of radiation sensitive adhesives by the addition of light-scattering particles, these particles serving the dual purposes of providing full illumination of the glue or adhesive by activating radiation which impacts less than the full surface; and providing a bodying effect to the glue or adhesive, which bodying effect increases the viscosity of the glue or adhesive. This increase in viscosity reduces the propensity of the glue or adhesive to run, and provides the property of being able to bridge a gap between the two members to be glued or adhered.

The present invention is particularly applicable to commercially available radiation sensitive adhesives, such as Dymax (registered trade mark) 628T brand (a product of American Chemical and Engineering Corp.) and Speedbonder 352 brand (a product of the Loctite Corp).

Automated assembly of parts dictates the use of fast-curing, low shrinkage, dimensionally stable adhesives. An exemplary use is the attachment of a head button to the accessing arm of a flexible data-recording disk drive. However, the present invention is not limited to this application, but is of general utility. Acrylic structural adhesives which cure with ultra-violet light are well suited for this purpose. However, the need critically to adjust the position of the head button often results in a gap between the head button and the accessing arm. An exemplary gap is 0.9 mm. Also, the construction and arrangement of the head button/accessing arm does not always leave the full surface available for direct application of the ultraviolet source. Thus the two characteristics above referred to are particularly useful.

In an embodiment of the present invention, a radiation sensitive adhesive, such as Dymax 628T or Speedbonder 352 is modifed by the addition of glass beads, about 0.045 mm in diameter. Equal weights of adhesive and glass beads are used. The method of mixing the beads and adhesive is not critical, provided the beads are quite uniformly distributed throughout the bulk of the adhesive. Preferably, the glass beads are first surface-treated with a silane coupling agent which is compatible with the polymer of the adhesive. These pretreated particles stay better in suspension during storage of the adhesive.

The new and unusual results achieved by the present invention are demonstrated by the following test results.

Disk drive head and accessing arm components were held with a gap of 1.5 millimetres therebetween. Adhesive in the amount of 0.03 grammes was applied at two 180°-spaced areas in this gap. The exposed glue was subjected to a 15-second burst of high intensity ultraviolet light as provided by a 350-watt mercury arc lamp. The samples were at the focal point of a long-focus lens, some 0.3048 m (12 inches) away.

The following forces were required to separate the parts. The data represents an average of three replicate tests.

| | Adhesive | Breaking force | |
|---|---|---|---|
| | | lbs. | kg |
| (1) | Dymax 628T | 6.5 | 2.9484 |
| (2) | Dymax 628T, with glass beads, equal amounts by weight | 16.5 | 7.4844 |
| (3) | Speedbonder 352 | 8.2 | 3.71952 |
| (4) | Speedbonder 352, with glass beads, equal amounts by weight | 13.7 | 6.21432 |

As shown, substantial improvement in bond strength occurs with the addition of the glass beads. Visual inspection of the dark area of the broken bonds for inspection of the dark area of the broken bonds for adhesives (1) and (3) showed uncured adhesive in the areas which did not receive direct radiation from the ultraviolet source. Adhesives (2) and (4) did not show this

phenomenon because the glass beads operate to distribute or scatter the ultraviolet radiation inside the bond, by internal reflection. Other light scattering particles, which are compatible with the adhesive or glue, will perform the same results.

By distributing radiation, in the form of ultraviolet light, throughout the adhesive, the light scattering particles, in the form of glass beads, enable the adhesive to be cured substantially uniformly between two bodies, non-transparent to the curing radiation.

## Claims

1. A radiation sensitive adhesive characterised by the addition of adhesive-compatible radiation-scattering particles of glass beads to the adhesive.

2. An adhesive according to claim 1, in which, prior to addition, the particles are treated with an adhesive-compatible surface treating agent.

3. An adhesive according to claim 1 or 2, in which the particles are about 45 μm in diameter.

4. An adhesive according to claim 1, 2 or 3, in which the adhesive is curable by ultraviolet light.

5. An adhesive according to claim 1, in which the glass beads are pretreated with an adhesive-compatible silane coupling agent.

6. An adhesive according to any preceding claim in which the adhesive and particles are mixed in about equal amounts by weight.

7. An adhesive according to any preceding claim, in which the adhesive is an acrylic structured adhesive.

8. A method of bonding two spaced members, comprising the steps of positioning the two members with a gap therebetween, closing the gap with a radiation sensitive adhesive which includes radiation-scattering glass beads, which increase the body or viscosity of the adhesive, and flooding the exposed portions of the adhesive with activating radiation.

9. A method according to claim 8, in which the adhesive is one according to any of claims 1 and 7.

10. A member according to claim 8 or 9, in which the two members are a magnetic head and a mount for a head.

## Patentansprüche

1. Strahlungsempfindlicher Kleber, gekennzeichnet durch die Zugabe von kleberverträglichen strahlungsstreuenden Teilchen aus Glaskügelchen zum Kleber.

2. Kleber nach Anspruch 1, bei welchem die Teilchen vor der Zugabe mit einem kleberverträglichen Oberflächenbehandlungsmittel behandelt sind.

3. Kleber nach Anspruch 1 oder 2, bei welchem die Teilchen einen Durchmesser von ungefähr 45 μm haben.

4. Kleber nach Anspruch 1, 2 oder 3, bei welchem der Kleber durch ultraviolettes Licht härtbar ist.

5. Kleber nach Anspruch 1, bei welchem die Glaskügelchen mit einem kleberverträglichen Silan-Haftvermittler vorbehandelt sind.

6. Kleber nach irgendeinem vorstehenden Anspruch, bei welchem der Kleber und die Teilchen in ungefähr gleichen Gewichtsmengen gemischt sind.

7. Kleber nach irgendeinem vorstehenden Anspruch, bei welchem der Kleber ein Acrylstruktur-Kleber ist.

8. Verfahren zur Verbindung von zwei im Abstand liegenden Elementen, welches die Verfahrensschritte des Anordnens der beiden Elemente unter Einhaltung eines Zwischenraums, des Schließens des Zwischenraums mit strahlungsempfindlichem Kleber, welcher strahlungsstreuende Glaskügelchen enthält, welche die Füllkraft bzw. Viskosität des Klebers erhöhen, und des Flutens der freiliegenden Abschnitte des Klebers mit aktivierender Strahlung umfaßt.

9. Verfahren nach Anspruch 8, bei welchem der Kleber einer nach irgendeinem der Ansprüche 1 bis 7 ist.

10. Verfahren nach Anspruch 8 oder 9, bei welchem die beiden Elemente ein Magnetkopf und ein Träger für einen Kopf sind.

## Revendications

1. Un adhésif sensible au rayonnement, caractérisé par l'addition à l'adhésif de particules formées par des perles de verre, compatibles avec l'adhésif et dispersant le rayonnement.

2. Un adhésif conforme à la revendication 1, dans lequel, avant l'addition, les particules sont traitées avec un agent de traitement de surface compatible avec l'adhésif.

3. Un adhésif selon la revendication 1 ou 2, dans lequel les particules ont un diamètre d'environ 45 μm.

4. Un adhésif selon la revendication 1, 2 ou 3, qui peut être durci par une lumière ultraviolette.

5. Un adhésif selon la revendication 1, dans lequel les perles de verre sont prétraitées avec un agent de liaison de silane, compatible avec l'adhésif.

6. Un adhésif selon une quelconque des revendications précédentes, où l'adhésif et des particules sont mélangés en quantités pondérales à peu près égales.

7. Un adhésif selon une quelconque des revendications précédentes, où l'adhésif est un adhésif à structure acrylique.

8. Un procédé de liaison de deux pièces espacées, comprenant les étapes consistant à positionner les deux éléments avec un intervalle entre eux, à fermer l'intervalle avec un adhésif sensible à un rayonnement qui contient des perles de verre à dispersion de rayonnement, qui augmentent la cohésion ou la viscosité de l'adhésif, et à soumettre les parties exposées de l'adhésif à un rayonnement d'activation.

9. Un procédé selon la revendication 8, où

5 **0 097 225** 6

l'adhésif est conforme à une quelconque des revendications 1 et 7.

10. Un procédé selon la revendication 8 ou 9, où les éléments à assembler sont constitués par une tête magnétique et un support de tête.